# EUROPEAN PATENT SPECIFICATION

(11) **EP 4 230 590 B1**
(45) Date of publication and mention of the grant of the patent: **18.02.2026**
(21) Application number: 21892286.2
(22) Date of filing: 09.11.2021
(51) Int. Cl.: C02F 3/00, F26B 3/04, F26B 21/10, F26B 23/00, F28D 21/00, H05K 7/20, C02F 11/04, C02F 11/12, C02F 11/13

(54) **SYSTEM FOR ECO-FRIENDLY HEAT EXCHANGE BETWEEN WATER TREATMENT DEVICE AND EXTERNAL PLANT**
SYSTEM FÜR UMWELTFREUNDLICHEN WÄRMEAUSTAUSCH ZWISCHEN EINER WASSERBEHANDLUNGSVORRICHTUNG UND EINER EXTERNEN ANLAGE
SYSTÈME D'ÉCHANGE DE CHALEUR ÉCOLOGIQUE ENTRE UN DISPOSITIF DE TRAITEMENT DES EAUX ET UNE INSTALLATION EXTERNE

(30) Priority: 11.11.2020 KR 20200150221
(43) Date of publication of application: 23.08.2023
(73) Proprietor: BKT Co., Ltd., Daejeon 34109 (KR)
(72) Inventor: KIM, Minyoung, Daejeon 34021 (KR); KIM, Dongwoo, Daejeon 34021 (KR); KIM, Sukwoo, Yanggu-gun, Gangwon-do 24507 (KR); CHOI, Munchin, Daejeon 34094 (KR); KANG, Shinjoh, Ann Arbor, Michigan 48104 (US); KIM, Junghoon, Ansan-si, Gyeonggi-do 15623 (KR); LEE, Chunwoo, Busan 48054 (KR); RHU, Daehwan, Yeoju-si, Gyeonggi-do 12641 (KR); KIM, Jaemin, Sejong-si 30100 (KR); CHOI, Ran, Daejeon 34199 (KR); HWANG, Jungjoon, Daejeon 34166 (KR); LEE, Dongsun, Daejeon 34867 (KR); KIM, Mingyun, Daejeon 35250 (KR); PARK, Sehee, Daejeon 34116 (KR); BAE, Jinseok, Daejeon 34109 (KR); NAM, Yunwoo, Sejong-si 30146 (KR); KIM, Yunjin, Daejeon 34195 (KR); MOON, Sein, Daejeon 34383 (KR)
(74) Representative: ABG Intellectual Property Law, S.L.
(86) International application number: PCT/KR2021/016240
(87) International publication number: WO 2022/103118

(56) References cited:
- CN-A- 102 711 417
- CN-A- 107 726 424
- DE-A1- 2 100 521
- KR-A- 20130 135 327
- KR-A- 20160 093 873
- KR-B1- 101 616 417
- KR-B1- 101 737 631
- KR-B1- 101 932 611
- KR-B1- 102 045 191
- US-A1- 2010 243 544

## Description

### [Technical Field]

The present invention relates to a heat exchange system for reusing waste heat by exchanging the waste heat between a water treatment device in a sewage treatment plant and an external plant such as a data center.

### [Background Art]

A water treatment device in a sewage treatment plant refers to an individual technology or system of the sewage treatment plant that purifies and treats contaminated water such as sewage, dirty water, and wastewater. A method of treating sewage may be different depending on a type of pollutant to be removed. However, in general, solids are physically or chemically removed, and organic matters, nitrogen, phosphorus, and the like are removed by biological treatment with microorganisms. For the biological treatment, a reactor for culturing microorganisms that survive by feeding on pollutants is required, and a temperature of the reactor is very important for growth and activation of microorganisms. In particular, a decrease in water temperature in winter causes a problem of lowering biological reaction efficiency by lowering microbial activity. As long as the water temperature does not exceed 40°C, the higher the water temperature, the better the biological treatment efficiency, which may reduce operating costs such as energy costs and stably secure effluent quality. If a heat source may be supplied to the sewage treatment plant at a low cost or free of charge, the heat source may increase operational efficiency of a biological reaction and may be used for drying sludge or the like that is generated during sewage treatment. In this way, the operating costs of the sewage treatment plant may be saved, and carbon emission may be reduced by reducing energy consumption.

On the other hand, there are various industrial plants that generate a large amount of heat during operation. Conventionally, heat is mainly generated in plants that produce chemicals or specific products, but recently, with the development of the data communication industry, heat generation in data centers is becoming a problem. The data center is a facility that is connected to external communication networks such as the Internet to store data transmitted and received through external communication networks. Not only portal site operators or cloud service providers, but also public institutions are operating large-scale data centers to store a large amount of data. These data centers are preferably installed in suburbs of cities in consideration of the convenience of securing competent working manpower, security, and electric power, connectivity with the external communication networks, and the like, but are causing many problems, such as difficulty in securing a site, power shortage due to a large amount of energy required to cool the generated heat, global warming, and the occurrence of an urban heat island phenomenon.

Document CN107726424A discloses a sewage source heat pump and data center composited clean cold-supply and heat-supply system and method.

Document CN102711417A discloses a data center and a data center cooling system.

Document DE2100521A1 discloses a method for controlling the temperature in a biological degradation plant, in particular in a wastewater treatment plant, and to a device for carrying out the method.

Document US2010/243544A1 discloses a sewage treatment apparatus and sewage reuse system.

### [Disclosure]

### [Technical Problem]

As described above, the sewage treatment plant wants to economically receive an appropriate heat source for biological treatment efficiency, economical sludge treatment, or the like, and the external plants such as the data centers want to overcome carbon emissions, power shortages, and the heat island effect by removing the generated heat. The present invention has been devised in view of such circumstances, and is to simultaneously solve various problems in terms of environmental and economic aspects by enabling complementary heat exchange between an external plant and a sewage treatment plant.

### [Technical Solution]

The present invention provides a heat exchange system between an external plant that generates heat during operation and acts as a heat source for the surrounding environment and a water treatment device for treating sewage. According to the present invention, the heat exchange system includes a hot-air supply unit that supplies heat generated from the external plant to a reactor using microorganisms in the water treatment device, a coolant supply unit that supplies treated water discharged from the water treatment device to the external plant as a coolant for heat dissipation of the external plant, and a control unit that controls an operation of the hot-air supply unit and the coolant supply unit.

The external plant may include a data center that transmits and receives data through an external communication network and stores the data.

The hot-air supply unit includes a hot-air pipe that provides a hot-air movement path between the reactor and a heat exchanger provided in the external plant, and a blower that blows hot air from the heat exchanger to the reactor through the hot-air pipe.

The hot-air pipe further provides a hot-air movement path between the heat exchanger and a dryer for drying sludge generated in the reactor, and the blower blows hot air from the heat exchanger to the dryer through the hot-air pipe.

A valve is installed on the hot-air movement path of the hot-air pipe to control a supply of the hot air to the reactor and the dryer through the hot-air pipe. The control unit controls the valve so that the supply of the hot air to the reactor and the dryer is individually regulated.

The coolant supply unit may include at least one of a first cooling pipe that supplies the treated water to the heat exchanger provided in the external plant, a second cooling pipe that is installed outside the external plant or buried in an outer wall of the external plant and supplied with the treated water, a sprinkler that cools the external plant by sprinkling the treated water to the outside of the external plant or supplies water to plants planted in the external plant for building greening, and a sprayer that sprays the treated water to outside air supplied for cooling the external plant.

The coolant supply unit may further include a pump that supplies the treated water to at least one of the first cooling pipe, the second cooling pipe, the sprinkler, and the sprayer.

The coolant supply unit may further include a recovery pipe that recovers some or all of the treated water, which is supplied to the external plant and used for cooling, to the water treatment device.

The coolant supply unit may further include a storage unit that stores the treated water to be supplied to the external plant.

The coolant supply unit may further include a circulation pipe that circulates some or all of the treated water, which is supplied to the external plant and used for cooling, to the storage unit.

The coolant supply unit may further include a cooler that cools the treated water stored in the storage unit.

The coolant supply unit may further include a fuel cell that generates electric power to be supplied to the cooler by using biogas generated in the reactor as a fuel.

Some of the electric power output from the fuel cell may be supplied to the external plant.

The coolant supply unit may further include a turbine that generates electric power to be supplied to the cooler by burning the biogas generated in the reactor.

Some of the electric power output from the turbine may be supplied to the external plant.

The heat exchange system may further include a converter that converts carbon dioxide generated by burning the biogas into ethanol and supplying the ethanol to the reactor.

When a temperature of the hot air supplied to the reactor through the hot-air supply unit is higher than that required for activation of the microorganisms in the reactor, the coolant supply unit may supply some or all of the treated water to an outside of the hot-air pipe to cool the hot air supplied through the hot-air pipe.

The control unit may control an operation of the hot-air supply unit and the coolant supply unit based on any one of a temperature of the hot air, a temperature of the reactor, a temperature of the external plant, water quality of the treated water, a temperature of the treated water, and a sewage treatment capacity of the water treatment device.

### [Advantageous Effects]

According to the present invention, heat generated in an external plant such as a data center that uses a huge cost for cooling is recovered and used for various purposes in a sewage treatment plant. When a cooling method of an external plant such as a data center is air cooling, hot air generated from a data center is supplied to a sewage treatment plant and used for sewage treatment or sludge drying. When a method of cooling an external plant is water cooling, treated water from a sewage treatment plant is used as a coolant supply source to remove heat from the external plant. Treated water recovering heat in a data center is used directly as influent of the sewage treatment plant or used to raise a temperature of the sewage treatment plant by allowing a pipe of the treated water to pass through the influent or a biological reactor of the sewage treatment plant.

A complementary heat exchange between an external plant to remove heat and a sewage treatment plant that requires heat helps to solve social and environmental problems, such as climate change and heat island control, as well as stable and economical operation of both facilities. Various heat exchange methods described above may be applied independently or may be used together.

It is possible to implement an automatic operation that may increase economic efficiency and effectiveness by selectively using various cooling methods at the same time or individually according to characteristics of season or temperature. For efficient and stable heat exchange operation, an AI-based optimal operation system may be applied. An operation system selects an optimal heat exchange method based on real-time monitoring data such as temperature, humidity, and electric energy of a data center and a sewage treatment plant, and suggests stable driving by predicting the amount of heat generated by applying a machine learning algorithm and early warning.

By building a sewage treatment plant underground and building a data center on the ground above the sewage treatment plant, it is possible to have a great effect in solving a site problem of the sewage treatment plant and the data center and coping with climate change and a heat island effect.

### [BRIEF DESCRIPTION OF THE DRAWINGS]

FIG. 1 is a diagram schematically illustrating a complementary heat exchange situation between a water treatment device and a data center by a heat exchange system according to the present invention.
FIG. 2 is a diagram illustrating a state in which a water treatment device is installed in a way that is buried underground as another example of FIG. 1.
FIG. 3 is a block diagram illustrating a configuration of a heat exchange system according to the present invention.
FIG. 4 is a block diagram illustrating a state in which the heat exchange system of FIG. 3 is applied to a water treatment device and a data center.
FIG. 5 is a diagram illustrating a state in which a detailed configuration of the present invention is additionally provided in the heat exchange system of FIG. 4.

### [Best Mode]

Hereinafter, the present disclosure will be described in more detail with reference to the accompanying drawings.

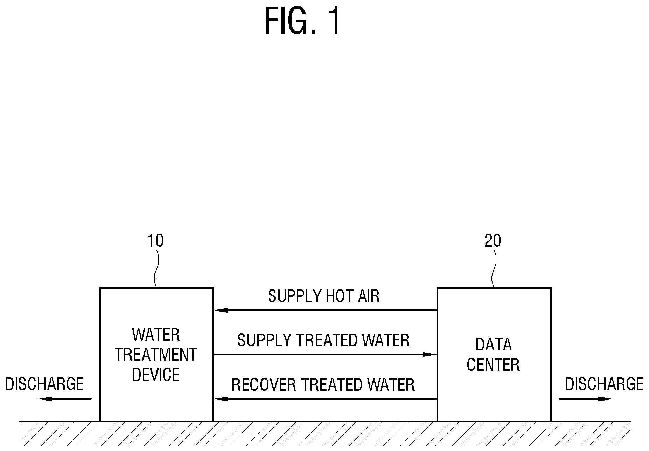

FIG. 1 is a diagram schematically illustrating a complementary heat exchange situation between a water treatment device and a data center by a heat exchange system according to the present invention.

The present invention exemplifies, as an example of an external plant, a data center 20 that transmits and receives data through an external communication network and stores the data. However, the data center 20 is only an example of an external plant to which the heat exchange system of the present invention is applied, and the present invention may be applied to other industrial facilities, which generate heat and require heat dissipation, in addition to the data center 20. That is, the external plant of the present invention includes all kinds of facilities that generate heat during operation and act as a heat source for the surrounding environment. According to the present invention, the water treatment device 10 is a facility that requires a supply of hot air for activating microorganisms by including a reactor for water treatment using the microorganisms, and the facility includes a facility for drying sludge generated during sewage treatment, etc.

The heat exchange system according to the present invention implements complementary heat exchange between the water treatment device 10 and the data center 20. The water treatment device 10 and the data center 20 are installed at a location adjacent to each other, and the heat exchange system is disposed therebetween or disposed inside the water treatment device 10 and the data center 20, respectively. The heat exchange system supplies some or all of the hot air generated in the data center 20 to the water treatment device 10, and the water treatment device 10 supplies some or all of treated water with clean water as a result of treating sewage to the data center 20. The treated water used as coolant in the data center 20 is recovered by the water treatment device 10 again, and thus, is used as a heat source of the water treatment device 10 and at the same time is re-treated by the water treatment device 10 to be purified with treated water having higher quality water.

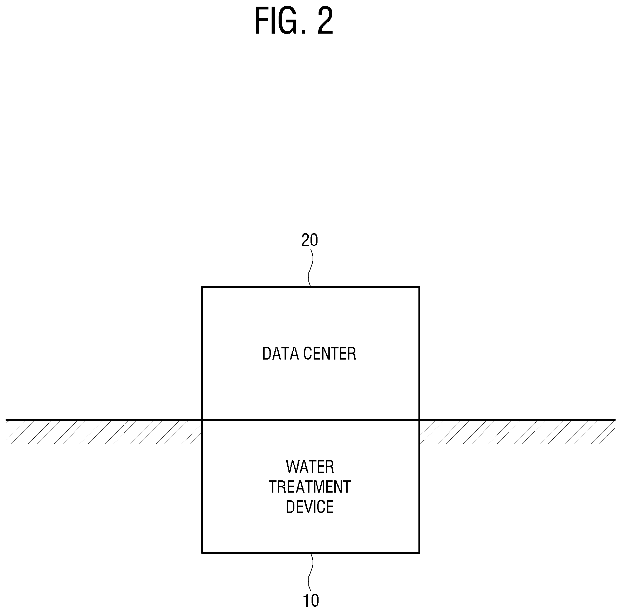

FIG. 2 is a diagram illustrating a state in which a water treatment device is installed in a way that is buried underground as another example of FIG. 1. The present invention may be applied when the water treatment device 10 and the data center 20 are installed on the ground as illustrated in FIG. 1, but may also be applied when the water treatment device 10 is buried underground as illustrated in FIG. 2. In this case, an area of a site required for installing the water treatment device 10 and the data center 20 is reduced, so the present invention may be more economically implemented.

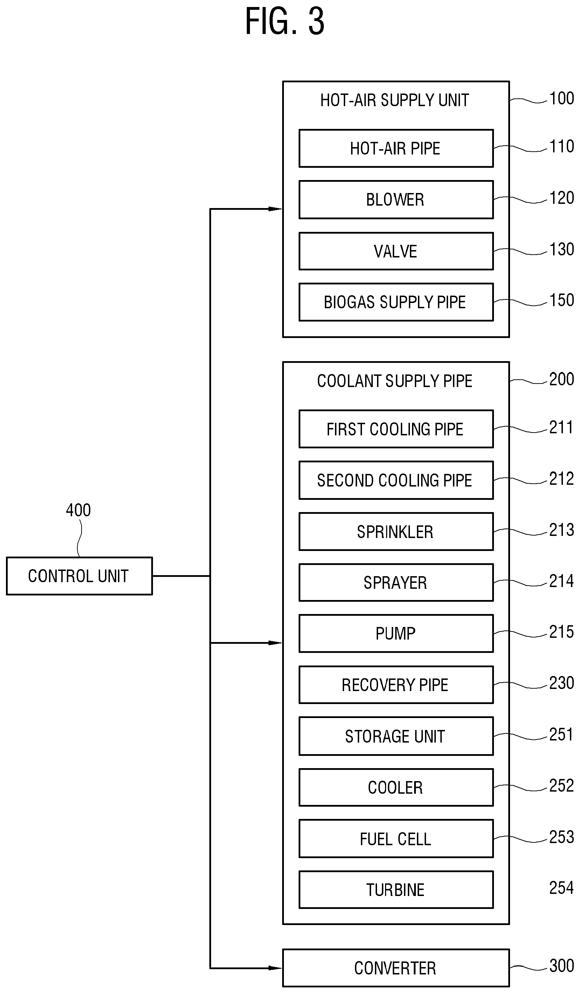

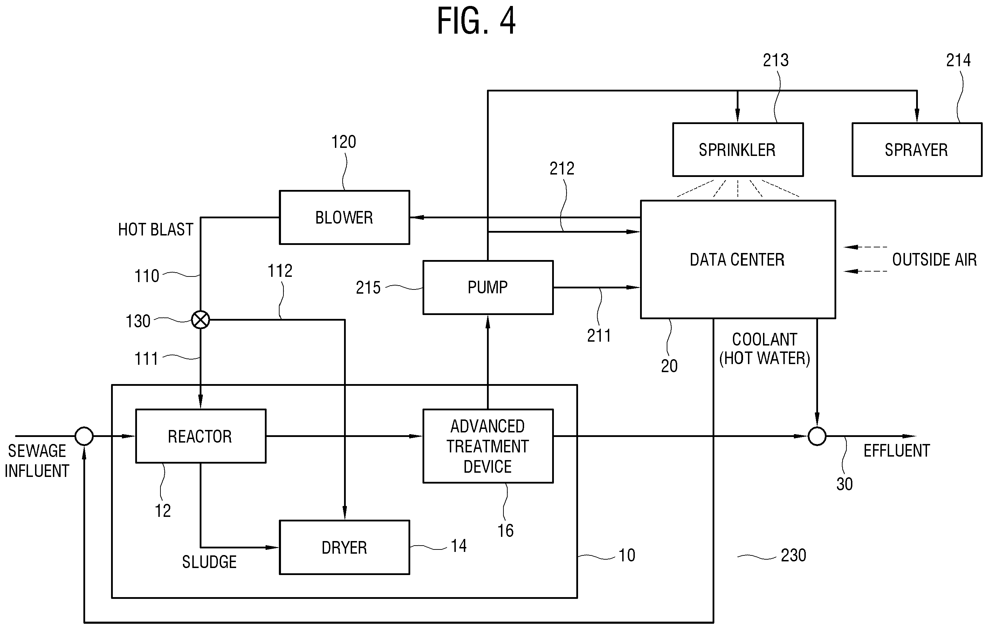

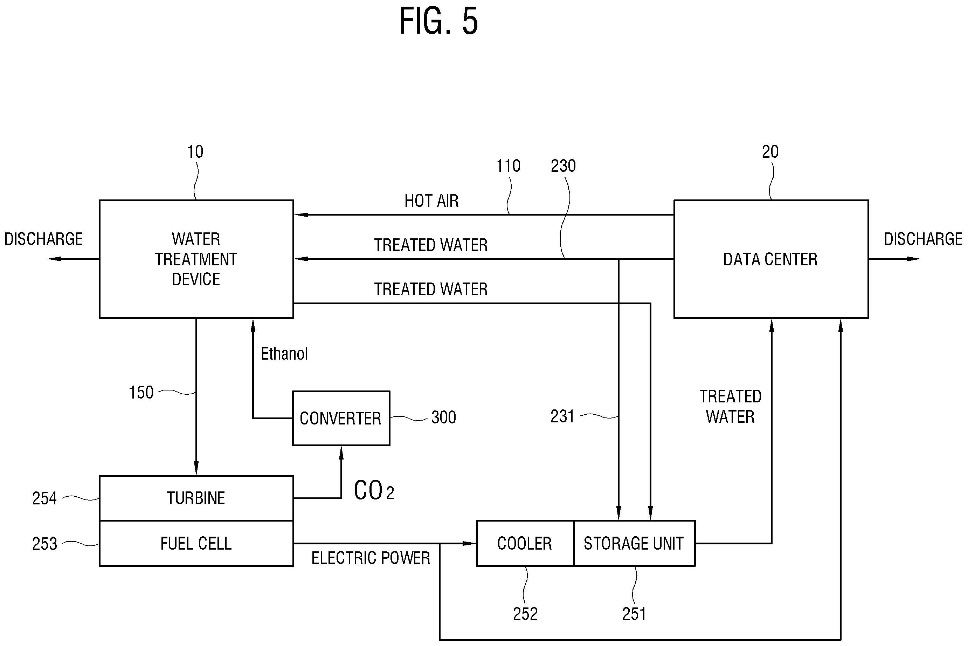

FIGS. 3 to 5 are diagrams illustrating a heat exchange system according to the present invention. FIG. 3 is a block diagram illustrating a configuration of a heat exchange system according to the present invention. FIG. 4 is a block diagram illustrating a state in which the heat exchange system of FIG. 3 is applied to the water treatment device 10 and the data center 20, and is a diagram mainly illustrating a configuration directly related to heat exchange among the configurations of the heat exchange system of the present invention. FIG. 5 is a diagram illustrating a detailed configuration additionally provided to the configuration of FIG. 4 so that the heat exchange system of FIG. 4 has high heat exchange efficiency and an eco-friendly configuration.

The water treatment device 10 to which the present invention is applied includes a reactor 12, a dryer 14, and an advanced treatment device 16. The reactor 12 accommodates microorganisms, and treats incoming sewage by the microorganisms. The treated water treated in the reactor 12 is supplied to the advanced treatment device (16) as needed to be secondarily treated with better quality water. Sludge generated in the reactor 12 is supplied to the dryer 14 and dried in the form of a dewatering cake. The dryer 14 supplies hot blast to sludge in order to dry the sludge. The heat exchange system of the present invention uses the treated water discharged from the conventional water treatment device 10 to cool the data center 20.

The data center 20 has a heat exchanger (not shown) therein. The heat exchanger sucks air from the outside of the data center 20 and supplies the sucked air to the inside of the data center 20 to cool heat generated by the operation of the data center 20, and discharges the hot air, whose temperature has increased by being used for cooling, to the outside. The heat exchange system of the present invention uses hot air generated and discharged by the cooling system of the typical data center 20 as a heat source supplied to the water treatment device 10.

The heat exchange system of the present invention includes a hot-air supply unit 100, a coolant supply unit 200, a converter 300, and a control unit 400. The hot-air supply unit 100 serves to supply the hot air generated in the data center 20 to the reactor 12 in the water treatment device 10, and the coolant supply unit 200 serves to supply the treated water discharged from the water treatment device 10 to the data center 20 as a coolant for heat dissipation of the data center 20. As will be described later, the converter 300 serves to convert carbon dioxide generated when biogas generated in the reactor 12 is burned into ethanol and supply the ethanol to the reactor 12. The control unit 400 serves to control the overall operation of the detailed configuration of the heat exchange system of the present invention, including the operation of the hot-air supply unit 100, the coolant supply unit 200, and the converter 300.

The hot-air supply unit 100 includes a hot-air pipe 110, a blower 120, a valve 130, and a biogas supply pipe 150.

The hot-air pipe 110 provides a hot-air movement path between the heat exchanger in the data center 20 and the reactor 12 in the water treatment device 10. The hot-air pipe 110 includes a first hot-air pipe 111 and a second hot-air pipe 112, which are branched from the hot-air pipe 110 to connect to a reactor 12 and a dryer 14, respectively. Accordingly, the first hot-air pipe 111 provides the hot-air movement path from the heat exchanger in the data center 20 to the reactor 12, and the second hot-air pipe 112 provides the hot-air movement path from the heat exchanger in the data center 20 to the dryer 14.

The blower 120 serves to blow the hot air supplied through the hot-air pipe 110 to the reactor 12 and the dryer 14. In this case, the hot air blown by the blower 120 is supplied to the reactor 12 through the first hot-air pipe 111 and is supplied to the dryer 14 through the second hot-air pipe 112.

The valve 130 is installed on the hot-air movement path of the hot-air pipe 110 to control the supply of hot air to the reactor 12 and the dryer 14 through the hot-air pipe 110. The valve 130 is installed at a branch point of the first hot-air pipe 111 and the second hot-air pipe 112 in the hot-air movement path of the hot-air pipe 110 or in installed in the first hot-air pipe (111) and the second hot-air pipe (112), respectively, to individually control the supply of hot air to the reactor 12 and the drier 14 through the first hot-air pipe 111 and the second hot-air pipe 112. An opening/closing operation of the valve 130 is controlled by the control unit 400. As an example, the control unit 400 opens the first hot-air pipe 111 to supply hot air into the reactor 12 when the temperature in the reactor 12 is 25°C or lower, and opens the second hot-air pipe 112 to supply the hot air into the dryer 14 when the temperature in the reactor 12 is 35°C or higher.

The biogas supply pipe 150 provides a path for supplying biogas generated during the treatment by microorganisms in the reactor 12 to a fuel cell 253 or a turbine 254.

The coolant supply unit 200 includes a first cooling pipe 211, a second cooling pipe 212, a sprinkler 213, a sprayer 214, a pump 215, a recovery pipe 230, a storage unit 251, a cooler 252, a fuel cell 253, and a turbine 254.

The first cooling pipe 211 provides a path for supplying the treated water discharged from the water treatment device 20 to the heat exchanger in the data center 20. The heat exchanger of the data center 20 performs cooling operation in a water cooling type by the treated water supplied through the first cooling pipe 211. The second cooling pipe 212 is installed outside in a shape surrounding the outer wall of the data center 20 or is installed to be buried in the outer wall of the data center 20 to provide a path for supplying treated water to the outside of the data center 20. Accordingly, heat generated from the outer wall of the data center 20 is absorbed by the treated water, so the outer wall is cooled.

The sprinkler 213 serves to sprinkle the treated water on the outer wall or roof of the data center 20. Accordingly, the heat generated from the outer wall or roof of the data center 20 is absorbed by vaporization of the sprinkled treated water. In addition, the sprinkler 213 may also serve to supply water necessary for growth of plants using treated water when there are plants planted on a roof of a building, for example, for greening the building using plants. The sprayer 214 serves to spray the treated water to an inlet side of the outdoor air supplied for cooling the data center 20. Accordingly, moisture is contained in the outside air flowing into the heat exchanger in the data center 20, and the efficiency of cooling of the data center 20 in an air cooling type is further increased. The treated water may be supplied to the sprinkler 213 and the sprayer 214 through separate pipes branched from the cooling pipes 211 and 212.

The pump 215 supplies the treated water to the first cooling pipe 211, the second cooling pipe 212, the sprinkler 213, and the sprayer 214. Specifically, the treated water discharged from the reactor 12 is supplied to the advanced treatment device 16 to be further treated, and the treated water discharged from the advanced treatment device 16 is pumped by the pump 215 and supplied to the first cooling pipe 211, the second cooling pipe 212, the sprinkler 213, and the sprayer 214. Separate valves (not illustrated) for individually controlling the supply of treated water are installed in the first cooling pipe 211, the second cooling pipe 212, the sprinkler 213, and the sprayer 214, and thus, are preferably configured to selectively supply treated water to some or all of the first cooling pipe 211, the second cooling pipe 212, the sprinkler 213, and the sprayer 214 by the pump 215. An opening/closing operation of each valve 130 is controlled by the control unit 400.

The recovery pipe 230 provides a path for recovering some or all of the treated water, which is supplied to the data center 20 and used for cooling, to the water treatment device 20. Specifically, the recovery pipe 230 returns treated water discharged from the data center 20 to a front end of the reactor 12, that is, a sewage inlet through which sewage flows into the reactor 12, and supplies the treated water to the reactor 12. Accordingly, all or some of the treated water used for cooling in the data center 20 returns to the reactor 12, and the unreturned treated water is discharged to the outside through the discharge pipe 30. As an example, when it is necessary to increase the temperature in the reactor 12 or the quality of the treated water is unsuitable for discharge, the treated water is recovered to the water treatment device 20, and the treated water is discharged to the outside when there is no need to increase the temperature in the reactor 12 and the quality of the effluent meets the discharge standards.

Meanwhile, since the treated water discharged from the data center 20 is heated by the heat exchanger and has the high temperature, there is a risk of causing another environmental problem when directly discharged to the outside. Therefore, it is preferable that most or all of the treated water discharged from the data center 20 returns to the water treatment device 10, and the discharge of the treated water to the outside is made only in the water treatment device 10. Of the treated water discharged from the water treatment device 10, the treated water to be discharged to the outside is discharged through the discharge pipe 30.

The storage unit 251 is disposed on the treatment water movement path between the water treatment device 10 and the data center 20. The storage unit 251 is configured as, for example, a water tank and serves to store the treated water to be supplied to the data center 20. By the storage unit 251, the amount of treated water discharged or circulated from the water treatment device 10 may be regulated in consideration of the amount required for cooling the data center 20.

The cooler 252 serves to cool the treated water stored in the storage unit 251. Since the treated water is cooled by the cooler 252 in a state in which the treated water is stored in the storage unit 251, when the treated water is supplied to the data center 20, the temperature is lowered, so the data center 20 may be cooled more effectively.

On the other hand, when the treated water discharged from the data center 20 is repeatedly used for cooling the data center 20 without recovering the treated water to the water treatment device 10 or discharging the treated water to the outside, it is preferable to circulate the treated water. To this end, the recovery pipe 230 preferably further includes a circulation pipe 231 as illustrated in FIG. 5. The circulation pipe 231 is branched from the recovery pipe 230 and provides a path for circulating the discharged water from the data center 20 to the storage unit 251. A valve (not illustrated) for controlling whether or not to supply the discharged water to the circulation pipe 231 is installed at the point where the circulation pipe 231 is branched from the recovery pipe 230. When the valve is controlled so that the discharged water from the data center 20 is supplied to the circulation pipe 231, the discharged water is supplied to the storage unit 251 and stored in the storage unit 251, and is cooled by the cooler 252 in the storage unit 251 and then reused for cooling the data center 20.

The fuel cell 253 generates electric power using biogas as a fuel. As described above, the biogas generated during the treatment by microorganisms in the reactor 12 is supplied to the fuel cell 253 through the biogas supply pipe 150. The fuel cell 253 generates electricity by using the biogas as a direct fuel, in which the generated electricity is used as a driving power supply of the cooler 252.

The turbine 254 burns the biogas to generate electric power. As described above, the biogas generated during the treatment by the microorganisms in the reactor 12 is also supplied to the turbine 253 through the biogas supply pipe 150. A burning device (not illustrated) for burning biogas is provided in the turbine 254, and the turbine 254 is driven by a expansion force of hot air generated as the biogas is burned by the combustion device to generate electricity. The generated electricity is used as a driving power supply of the cooler 252.

Both the fuel cell 253 and the turbine 254 may be installed, or only one of the fuel cell 253 and the turbine 254 may be installed. In addition, electricity generated by the fuel cell 253 and the turbine 254 may be stored by providing a separate storage battery.

By the fuel cell 253 and the turbine 254 configured as described above, the electric power used for the operation of the cooler 252 of the water treatment device 20 is obtained by recycling the biogas generated in the sewage treatment process of the water treatment device 20 itself. Therefore, in the process of cooling the treated water, a separate external power supply is not required or the need for the external power supply is reduced, making it possible to configure a more eco-friendly heat exchange system.

Meanwhile, to prepare for the case where the amount of electric power generated by the fuel cell 253 and the turbine 254 is not sufficient by only the biogas, the fuel cell 253 may be additionally supplied with fuel for power generation. On the other hand, when the power charged in the fuel cell 253 exceeds the required level for the operation of the cooler 252, extra electric power may be used as power required for an operation of various computers in the data center 20 or may be used to drive a fan for supplying external air necessary for cooling the data center 20.

The converter 300 converts carbon dioxide into ethanol. Carbon dioxide (CO₂) is generated while the biogas supplied to the turbine 254 is burned to drive the turbine 254, and the generated carbon dioxide may act as a cause of global warming. Therefore, the converter 300 receives carbon dioxide and converts the carbon dioxide into ethanol to minimize the generation of the carbon dioxide. The ethanol generated in the converter 300 is supplied to the reactor 12. The ethanol supplied to the reactor 12 performs a denitrification function on the sewage to be treated, and is used to increase the efficiency of the sewage treatment.

According to the present invention as described above, the heat generated in the external plant such as the data center 20 is used as a heat source for supplying hot air required by the water treatment device 10, and the treated water of the water treatment device 10 is also used as a coolant supply source for cooling the external plant 20. Accordingly, it is possible to supply economical hot blast through the complementary heat exchange between the external plant 20 and the water treatment device 10 and also to solve the heat island phenomenon.

Meanwhile, the heat exchange system of the present invention may be operated in an optimized manner in consideration of various factors in the actual operation process. For example, the need for cooling the data center 20 in summer is greater than the need for supplying hot air to the water treatment device 10, and vice versa in winter. Therefore, the control unit 400 strengthens the circulation of the treated water through the circulation pipe 231 in summer, and strengthens the operation of the blower 120 without circulating the treated water in winter to reduce energy costs. In addition, in the summer, it is necessary to increase the amount of treated water supplied to the data center 20 and lower the temperature of the treated water, so the control unit 400 strengthens the operation of the pump 215 and the operation of the cooler 252, and vice versa in winter.

In addition, the control unit 400 controls the temperature of the hot air to be lowered when the temperature of the hot air supplied to the reactor 12 through the hot-air supply unit 100 is higher than the temperature required for the activation of microorganisms in the reactor 12. Accordingly, the coolant supply unit 200 may be controlled to supply some or all of the treated water to the hot-air pipe 110 for cooling the hot air supplied through the hot-air pipe 110. Specifically, an additional treated water transfer pipe (not illustrated) or a spray nozzle through which the treated water discharged from the cooler 252 is sprayed toward the outside of the hot-air pipe 110 is provided, and the control unit 400 cools the outside of the hot-air pipe 110 by supplying or spraying the cooled treated water to the hot-air pipe 110 through the transfer pipe or the spray nozzle. Accordingly, the temperature of the hot air supplied to the reactor 12 may be maintained at an appropriate temperature suitable for the activation of the microorganisms in the reactor 12.

Furthermore, the control unit 400 may control the operation of the hot-air supply unit 100 and the coolant supply unit 200 according to a value obtained by measuring some or all of the temperature of hot air, the temperature of the reactor 12, the temperature of the data center 20, the quality of the treated water, the temperature of the treated water, and the sewage treatment capacity of the water treatment device. Accordingly, an optimized heat exchange performance may be exhibited.

Although the present invention has been described with reference to exemplary embodiments shown in the accompanying drawings, it is only an example. It will be understood by those skilled in the art that various modifications and equivalent other exemplary embodiments are possible from the present invention. Accordingly, a technical scope of the present invention is to be defined by the following claims.

## Claims

1. A heat exchange system between an external plant that generates heat during operation and acts as a heat source for surrounding environment and a water treatment device (10) for treating sewage, the heat exchange system comprising:
a hot-air supply unit (100) that supplies heat generated from the external plant to a reactor (12) using microorganisms in the water treatment device (10);
a coolant supply unit (200) that supplies treated water discharged from the water treatment device (10) to the external plant as a coolant for heat dissipation of the external plant; and
a control unit (400) that controls an operation of the hot-air supply unit (100) and the coolant supply unit (200);
wherein the hot-air supply unit (100) includes:
a hot-air pipe (110) that provides a hot-air movement path between the reactor (12) and a heat exchanger provided in the external plant, and between the heat exchanger and a dryer (14) for drying sludge generated in the reactor (12);
a blower (120) that blows hot air from the heat exchanger to the reactor (12) and to the dryer (14) through the hot-air pipe (110); and
the heat exchange system further comprising a valve (130) that is installed on the hot-air movement path of the hot-air pipe (110) to control a supply of the hot air to the reactor (12) and the dryer (14) through the hot-air pipe (110),
wherein the control unit (400) controls the valve (130) so that the supply of the hot air to the reactor (12) and the dryer (14) is individually regulated.

2. The heat exchange system of claim 1, wherein the external plant includes a data center (20) that transmits and receives data through an external communication network and stores the data.

3. The heat exchange system of claim 1, wherein the coolant supply unit (200) further includes at least one of:
a first cooling pipe (211) that supplies the treated water to the heat exchanger provided in the external plant;
a second cooling pipe (212) that is installed outside the external plant or buried in an outer wall of the external plant and supplied with the treated water;
a sprinkler (213) that cools the external plant by sprinkling the treated water to the outside of the external plant or supplies water to plants planted in the external plant for building greening; and
a sprayer (214) that sprays the treated water to outside air supplied for cooling the external plant.

4. The heat exchange system of claim 3, wherein the coolant supply unit (200) further includes a pump (215) that supplies the treated water to at least one of the first cooling pipe (211), the second cooling pipe (212), the sprinkler (213), and the sprayer (214).

5. The heat exchange system of claim 1, wherein the coolant supply unit (200) further includes a recovery pipe (230) that recovers some or all of the treated water, which is supplied to the external plant and used for cooling, to the water treatment device (10).

6. The heat exchange system of claim 1, wherein the coolant supply unit (200) further includes a storage unit (251) that stores the treated water to be supplied to the external plant.

7. The heat exchange system of claim 6, wherein the coolant supply unit (200) further includes a circulation pipe that circulates some or all of the treated water, which is supplied to the external plant and used for cooling, to the storage unit (251).

8. The heat exchange system of claim 6, wherein the coolant supply unit (200) further includes a cooler (252) that cools the treated water stored in the storage unit (251).

9. The heat exchange system of claim 8, wherein the coolant supply unit (200) further includes a fuel cell (253) that generates electric power to be supplied to the cooler (252) by using biogas generated in the reactor (12) as a fuel.

10. The heat exchange system of claim 9, wherein some of the electric power output from the fuel cell (253) is supplied to the external plant.

11. The heat exchange system of claim 8, wherein the coolant supply unit (200) further includes a turbine (254) that generates electric power to be supplied to the cooler (252) by burning the biogas generated in the reactor (12).

12. The heat exchange system of claim 11, wherein some of the electric power output from the turbine (254) is supplied to the external plant.

13. The heat exchange system of claim 11, further comprising:
a converter (300) that converts carbon dioxide generated by burning the biogas into ethanol and supplying the ethanol to the reactor (12).

14. The heat exchange system of claim 1, wherein the control unit (400) controls an operation of the hot-air supply unit (100) and the coolant supply unit (200) based on any one of a temperature of the hot air, a temperature of the reactor (12), a temperature of the external plant, water quality of the treated water, a temperature of the treated water, a sewage treatment capacity of the water treatment device (10).

## Patentansprüche

1. Ein Wärmeaustauschsystem zwischen einer externen Anlage, welche während eines Betriebs Wärme erzeugt und als eine Wärmequelle für die umgebende Umwelt wirkt, und einer Wasserbehandlungsvorrichtung (10) zum Behandeln von Abwasser, wobei das Wärmeaustauschsystem umfasst:
eine Heißluftzufuhreinheit (100), welche von der externen Anlage erzeugte Wärme einem Reaktor (12), welcher Mikroorganismen verwendet, in der Wasserbehandlungsvorrichtung (10) zuführt;
eine Kühlmittelzufuhreinheit (200), welche aus der Wasserbehandlungsvorrichtung (10) abgegebenes behandeltes Wasser der externen Anlage als ein Kühlmittel für eine Wärmeableitung der externen Anlage zuführt; und
eine Steuereinheit (400), welche einen Betrieb der Heißluftzufuhreinheit (100) und der Kühlmittelzufuhreinheit (200) steuert;
wobei die Heißluftzufuhreinheit (100) umfasst:
ein Heißluftrohr (110), welches einen Heißluftbewegungsweg zwischen dem Reaktor (12) und einem Wärmetauscher, welcher in der externen Anlage bereitgestellt ist, und zwischen dem Wärmetauscher und einem Trockner (14) zum Trocknen von in dem Reaktor (12) erzeugtem Schlamm bereitstellt;
ein Gebläse (120), welches Heißluft aus dem Wärmetauscher zu dem Reaktor (12) und zu dem Trockner (14) durch das Heißluftrohr (110) bläst; und
das Wärmeaustauschsystem ferner ein Ventil (130) umfasst, welches an dem Heißluftbewegungsweg des Heißluftrohrs (110) installiert ist, um eine Zufuhr der Heißluft zu dem Reaktor (12) und dem Trockner (14) durch das Heißluftrohr (110) zu steuern,
wobei die Steuereinheit (400) das Ventil (130) derart steuert, dass die Zufuhr der Heißluft zu dem Reaktor (12) und dem Trockner (14) individuell reguliert ist.

2. Das Wärmeaustauschsystem nach Anspruch 1, wobei die externe Anlage ein Datenzentrum (20) umfasst, welches Daten durch ein externes Kommunikationsnetzwerk sendet und empfängt und die Daten speichert.

3. Das Wärmeaustauschsystem nach Anspruch 1, wobei die Kühlmittelzufuhreinheit (200) ferner wenigstens eines umfasst aus:
einem ersten Kühlrohr (211), welches das behandelte Wasser dem Wärmetauscher, welcher in der externen Anlage bereitgestelltist, zuführt;
einem zweiten Kühlrohr (212), welches außerhalb der externen Anlage installiert oder in einer äußeren Wand der externen Anlage verborgen ist und dem das behandelte Wasser zugeführt wird;
einem Sprinkler (213), welcher die externe Anlage durch Sprenkeln des behandelten Wassers auf das Äußere der externen Anlage kühlt, oder Pflanzen Wasser zuführt, welche in der externen Anlage für Gebäudebegrünung gepflanzt sind; und
einem Sprüher (214), welcher das behandelte Wasser in eine Außenluft sprüht, welche zum Kühlen der externen Anlage zugeführt wird.

4. Das Wärmeaustauschsystem nach Anspruch 3, wobei die Kühlmittelzufuhreinheit (200) ferner eine Pumpe (215) umfasst, welche das behandelte Wasser wenigstens einem aus dem ersten Kühlrohr (211), dem zweiten Kühlrohr (212), dem Sprinkler (213) und dem Sprüher (214) zuführt.

5. Das Wärmeaustauschsystem nach Anspruch 1, wobei die Kühlmittelzufuhreinheit (200) ferner ein Rückführrohr (230) umfasst, welches einiges oder alles des behandelten Wassers, welches der externen Anlage zugeführt und zum Kühlen verwendet wird, an die Wasserbehandlungsvorrichtung (10) zurückführt.

6. Das Wärmeaustauschsystem nach Anspruch 1, wobei die Kühlmittelzufuhreinheit (200) ferner eine Speichereinheit (251) umfasst, welche das behandelte Wasser speichert, welches der externen Anlage zugeführt werden soll.

7. Das Wärmeaustauschsystem nach Anspruch 6, wobei die Kühlmittelzufuhreinheit (200) ferner ein Zirkulationsrohr umfasst, welches einiges oder alles des behandelten Wassers, welches der externen Anlage zugeführt und zum Kühlen verwendet wird, zu der Speichereinheit (251) zirkuliert.

8. Das Wärmeaustauschsystem nach Anspruch 6, wobei die Kühlmittelzufuhreinheit (200) ferner einen Kühler (252) umfasst, welcher das behandelte Wasser kühlt, welches in der Speichereinheit (251) gespeichert ist.

9. Das Wärmeaustauschsystem nach Anspruch 8, wobei die Kühlmittelzufuhreinheit (200) ferner eine Brennstoffzelle (253) umfasst, welche elektrische Energie, welche dem Kühler (252) zugeführt werden soll, durch Verwenden von in dem Reaktor (12) erzeugtem Biogas als ein Brennstoff erzeugt.

10. Das Wärmeaustauschsystem nach Anspruch 9, wobei einiges der elektrischen Energieausgabe von der Brennstoffzelle (253) der externen Anlage zugeführt wird.

11. Das Wärmeaustauschsystem nach Anspruch 8, wobei die Kühlmittelzufuhreinheit (200) ferner eine Turbine (254) umfasst, welche elektrische Energie, welche dem Kühler (252) zugeführt werden soll, durch Verbrennen des in dem Reaktor (12) erzeugten Biogases erzeugt.

12. Das Wärmeaustauschsystem nach Anspruch **11,** wobei einiges der elektrischen Energieausgabe von der Turbine (254) der externen Anlage zugeführt wird.

13. Das Wärmeaustauschsystem nach Anspruch **11,** ferner umfassend:
einen Umwandler (300), welcher durch Verbrennen des Biogases erzeugtes Kohlenstoffdioxid in Ethanol umwandelt und das Ethanol dem Reaktor (12) zuführt.

14. Das Wärmeaustauschsystem nach Anspruch 1, wobei die Steuereinheit (400) einen Betrieb der Heißluftzufuhreinheit (100) und der Kühlmittelzufuhreinheit (200) basierend auf jeglichem aus einer Temperatur der Heißluft, einer Temperatur des Reaktors (12), einer Temperatur der externen Anlage, Wasserqualität des behandelten Wassers, einer Temperatur des behandelten Wassers, einer Abwasserbehandlungskapazität der Wasserbehandlungsvorrichtung (10) steuert.

## Revendications

1. Système d'échange de chaleur entre une installation externe qui génère de la chaleur pendant le fonctionnement et agit comme une source de chaleur pour l'environnement ambiant et un dispositif de traitement de l'eau (10) destiné à traiter des eaux usées, le système d'échange de chaleur comprenant :
une unité d'alimentation en air chaud (100) qui fournit de la chaleur générée à partir de l'installation externe à un réacteur (12) en utilisant des micro-organismes dans le dispositif de traitement de l'eau (10),
une unité d'alimentation en liquide de refroidissement (200) qui fournit à l'installation externe l'eau traitée évacuée du dispositif de traitement de l'eau (10) en tant que liquide de refroidissement en vue d'une dissipation de chaleur de l'installation externe, et
une unité de commande (400) qui commande un fonctionnement de l'unité d'alimentation en air chaud (100) et de l'unité d'alimentation en liquide de refroidissement (200),
dans lequel l'unité d'alimentation en air chaud (100) comprend :
une conduite d'air chaud (110) qui fournit un trajet de déplacement d'air chaud entre le réacteur (12) et un échangeur de chaleur agencé dans l'installation externe, et entre l'échangeur de chaleur et un sécheur (14) destiné à sécher les boues générées dans le réacteur (12),
une soufflante (120) qui souffle de l'air chaud provenant de l'échangeur de chaleur vers le réacteur (12) et vers le sécheur (14), à travers la conduite d'air chaud (110), et
le système d'échange de chaleur comprenant en outre un clapet (130) qui est installé sur le trajet de déplacement d'air chaud de la conduite d'air chaud (110) pour commander une fourniture de l'air chaud au réacteur (12) et au sécheur (14) à travers la conduite d'air chaud (110),
dans lequel l'unité de commande (400) commande le clapet (130) de sorte que la fourniture de l'air chaud au réacteur (12) et au sécheur (14) est régulée individuellement.

2. Système d'échange de chaleur selon la revendication 1, dans lequel l'installation externe comprend un centre de données (20) qui émet et reçoit des données via un réseau de communication externe et stocke les données.

3. Système d'échange de chaleur selon la revendication 1, dans lequel l'unité d'alimentation en liquide de refroidissement (200) comprend en outre au moins un élément parmi :
une première conduite de refroidissement (211) qui fournit l'eau traitée à l'échangeur de chaleur agencé dans l'installation externe,
une seconde conduite de refroidissement (212) qui est installée à l'extérieur de l'installation externe ou enterrée dans une paroi extérieure de l'installation externe et alimentée en eau traitée,
un asperseur (213) qui refroidit l'installation externe en aspergeant l'extérieur de l'installation externe avec l'eau traitée ou qui fournit de l'eau à des plantes plantées dans l'installation externe pour l'écologisation des bâtiments, et
un pulvérisateur (214) qui pulvérise l'eau traitée sur l'air extérieur fourni pour refroidir l'installation externe.

4. Système d'échange de chaleur selon la revendication 3, dans lequel l'unité d'alimentation en liquide de refroidissement (200) comprend en outre une pompe (215) qui fournit l'eau traitée à au moins un élément parmi la première conduite de refroidissement (211), la seconde conduite de refroidissement (212), l'asperseur (213) et le pulvérisateur (214).

5. Système d'échange de chaleur selon la revendication 1, dans lequel l'unité d'alimentation en liquide de refroidissement (200) comprend en outre une conduite de récupération (230) qui récupère tout ou partie de l'eau traitée, qui est fournie à l'installation externe et utilisée pour le refroidissement, vers le dispositif de traitement d'eau (10).

6. Système d'échange de chaleur selon la revendication 1, dans lequel l'unité d'alimentation en liquide de refroidissement (200) comprend en outre une unité de stockage (251) qui stocke l'eau traitée à fournir à l'installation externe.

7. Système d'échange de chaleur selon la revendication 6, dans lequel l'unité d'alimentation en liquide de refroidissement (200) comprend en outre une conduite de circulation qui fait circuler tout ou partie de l'eau traitée, qui est fournie à l'installation externe et utilisée pour le refroidissement, jusqu'à l'unité de stockage (251).

8. Système d'échange de chaleur selon la revendication 6, dans lequel l'unité d'alimentation en liquide de refroidissement (200) comprend en outre un refroidisseur (252) qui refroidit l'eau traitée stockée dans l'unité de stockage (251).

9. Système d'échange de chaleur selon la revendication 8, dans lequel l'unité d'alimentation en liquide de refroidissement (200) comprend en outre une pile à combustible (253) qui génère de l'énergie électrique à fournir au refroidisseur (252) en utilisant du biogaz généré dans le réacteur (12) en tant que combustible.

10. Système d'échange de chaleur selon la revendication 9, dans lequel une partie de l'énergie électrique délivrée à la sortie de la pile à combustible (253) est fournie à l'installation externe.

11. Système d'échange de chaleur selon la revendication 8, dans lequel l'unité d'alimentation en liquide de refroidissement (200) comprend en outre une turbine (254) qui génère de l'énergie électrique à fournir au refroidisseur (252) en brûlant le biogaz généré dans le réacteur (12).

12. Système d'échange de chaleur selon la revendication **11,** dans lequel une partie de l'énergie électrique délivrée à la sortie de la turbine (254) est fournie à l'installation externe.

13. Système d'échange de chaleur selon la revendication **11,** comprenant en outre :
un convertisseur (300) qui convertit le dioxyde de carbone généré par la combustion du biogaz en éthanol et fournit l'éthanol au réacteur (12).

14. Système d'échange de chaleur selon la revendication 1, dans lequel l'unité de commande (400) commande un fonctionnement de l'unité d'alimentation en air chaud (100) et de l'unité d'alimentation en liquide de refroidissement (200) sur la base d'un paramètre quelconque parmi une température de l'air chaud, une température du réacteur (12), une température de l'installation externe, une qualité d'eau de l'eau traitée, une température de l'eau traitée et une capacité de traitement des eaux usées du dispositif de traitement de l'eau (10).
